Europäisches
Patentamt

European
Patent Office

Office européen
des brevets

(11)     **EP 2 884 291 B1**

(12)     **EUROPEAN PATENT SPECIFICATION**

(45) Date of publication and mention
of the grant of the patent:
**21.08.2019  Bulletin 2019/34**

(51) Int Cl.:
*G01R 31/08* $^{(2006.01)}$

(21) Application number: **13196662.4**

(22) Date of filing: **11.12.2013**

(54) **Fault location in electrical network**

Fehlerortung in elektrischem Netzwerk

Localisation des pannes dans un réseau électrique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**17.06.2015  Bulletin 2015/25**

(73) Proprietor: **ABB Schweiz AG
5400 Baden (CH)**

(72) Inventor: **Vanhala, Kari
65320 Vaasa (FI)**

(74) Representative: **Kolster Oy Ab
(Salmisaarenaukio 1)
P.O. Box 204
00181 Helsinki (FI)**

(56) References cited:
**JP-A- S5 950 373     US-A1- 2011 184 673**

- **WAIKAR D L ET AL: "FAULT IMPEDANCE
ESTIMATION ALGORITHM FOR DIGITAL
DISTANCE RELAYING", IEEE TRANSACTIONS
ON POWER DELIVERY, IEEE SERVICE CENTER,
NEW YORK, NY, US, vol. 9, no. 3, 1 July 1994
(1994-07-01), pages 1375-1382, XP000484969,
ISSN: 0885-8977, DOI: 10.1109/61.311165**

**Description**

FIELD OF THE INVENTION

The invention relates to a fault location in an electrical network. In particular, the invention relates to an estimation of a fault distance in an electrical network.

BACKGROUND OF THE INVENTION

A purpose of fault location identification in electrical networks, such as transmission networks and distribution networks, is to find, isolate and repair the fault as fast as possible. The fault may be for example a short circuit fault between two or more phase lines of a feeder in the network or an earth fault between the earth and one or more phase lines of the feeder in the network. Fast and accurate detection and localization of a fault is an essential factor for increasing both safety and power availability in the electrical networks.

Traditionally, faults have been located by a coupling experimentation method. This may, however, take some time and cause long-term interruptions in the power availability. A demand for shorter discontinuities in power delivery has therefore generated a need for computational methods for localization of the fault so that a faulted feeder section could be isolated from healthy sections of the feeder and power supply could be restored to healthy sections more rapidly.

In conventional computational methods quantities of the electrical network, such as voltage and current signals during the fault, are recorded, and these signal recordings are analysed for estimating a fault distance, i.e. a distance between the fault position in the feeder and the measurement position in the feeder where the recordings were taken. For achieving a sufficient reliability of the fault distance estimate these computational methods are based on post-event analysis, i.e. off-line analysis of the recordings. However, this does not in practice prevent unnecessary long power outages in healthy feeder sections, because any protective operations, which may be provided by electrical network protection devices intended to monitor and control the operation of the feeder may affect the other feeder sections interconnected with the faulty feeder section. US-publication 2011/184673 A1 and JP-publication S59 50373 A disclose examples of off-line analysis methods.

There are also available on-line fault distance estimation applications which estimate the fault distance on-line, i.e. during the presence of the fault. In these applications the determined fault distance estimate is triggered to be recorded by an external application, such as an application intended to provide a protective operation. A problem with these applications is that the timing of the triggering may take place either too early or too late for recording a sufficiently reliable fault distance estimate.

For the electrical network system, the less time the fault localization takes, the better, and therefore there is a need for solutions that provide a fast fault localization process with an adequate accuracy.

BRIEF DESCRIPTION OF THE INVENTION

An object of the present invention is to provide a novel method and a system for fault distance estimation triggering in an electrical network.

The invention is characterized by the features of the independent claims.

According to an embodiment of the method, the triggering for recording the at least one fault distance estimate is performed in response to a disappearance of the fault if no fault distance estimate for the fault has been triggered yet.

According to an embodiment of the method, the triggering for recording the at least one fault distance estimate is performed in response to a change in a fault type if no fault distance estimate for the fault has been triggered yet.

According to an embodiment of the method, the final fault distance estimate is determined as a filtered value of the sequence of the successive initial fault distance estimates.

According to an embodiment of the system, the convergence value is an absolute value of a maximum difference of the latest initial fault distance estimate for the sequence of the successive initial fault distance estimates, and the convergence parameter is a maximum variance allowed around the latest initial fault distance estimate.

According to an embodiment of the system, the system comprises means for performing the triggering for recording the at least one fault distance estimate in response to a disappearance of the fault if no fault distance estimate for the fault has been triggered yet.

According to an embodiment of the system, the system comprises means for performing the triggering for recording the at least one fault distance estimate in response to a change in a fault type if no fault distance estimate for the fault has been triggered yet.

According to an embodiment of the system, the system comprises means for determining a final fault distance estimate as a filtered value of a sequence of the successive initial fault distance estimates.

BRIEF DESCRIPTION OF THE DRAWINGS

In the following the invention will be described in greater detail by means of preferred embodiments with reference to the accompanying drawings, in which

Figure 1 is a schematic illustration of an electrical network;
Figure 2 is a schematic illustration of a method, in a form of a flow diagram, and a system for fault distance estimate triggering; and
Figure 3 is a schematic example of behaviour of a fault distance estimate in time.

For the sake of clarity, the figures show the embodiments in a simplified manner. In the figures, like reference signs identify like elements.

DETAILED DESCRIPTION OF THE INVENTION

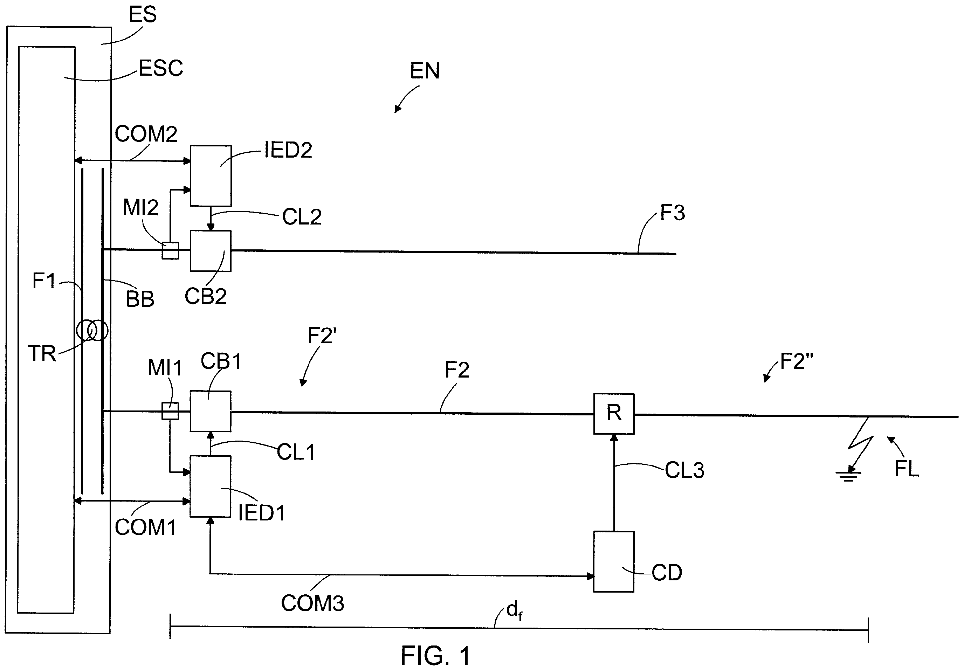

Figure 1 is a schematic illustration of an electrical network EN. Figure 1 schematically shows an electric station ES with one incoming feeder F1 and two outgoing feeders F2 and F3, the number of incoming feeders and outgoing feeders being not, however, limited to that shown in Figure 1. For the sake of clarity, only one line, i.e. a line denoted by reference sign F1, F2 or F3, is used to indicate all phase lines of the respective feeder, the actual number of the phase lines being dependent on local electricity distribution practices. In the following, it is assumed that the incoming feeder F1, which may also be called the first feeder F1, represents a high voltage transmission feeder and the outgoing feeders F2 and F3, which may also be called the second feeder F2 and the third feeder F3, represent medium voltage distribution feeders, whereby the electric station ES represents a primary distribution substation. The electric station ES comprises a busbar BB, which is connected to the feeder F1 through at least one transformer TR, the purpose of the transformer TR being to transform a high voltage level used in transmission lines into a medium voltage level used in medium voltage distribution lines. The outgoing feeders F2 and F3 are connected to the busbar BB, whereby the feeders F2 and F3 are connected galvanically to each other and whereby the electric station ES provides the main power supply for loads to be connected to the feeders F2 and F3. The electric station ES further comprises an electric station computer ESC, which may comprise a Supervisory Control and Data Acquisition system or a similar system for monitoring and controlling equipment at the electric station ES and/or equipment connected to the electrical network EN.

The electrical network EN of Figure 1 further comprises, at the beginning of the second feeder F2, a first circuit breaker CB1, and at the beginning of the third feeder F3, a second circuit breaker CB2. By opening the circuit breakers CB1 and CB2, the feeders F2 and F3 may be disconnected from the busbar BB for preventing power supply to the feeders F2 and F3, and by closing the circuit breakers CB1 and CB2 the feeders F2 and F3 may again be connected to the busbar BB for allowing power supply to the feeders F2 and F3. A need to disconnect the feeder F2 or F3 from the busbar BB may arise because of a fault in either of the feeders F2 and F3, whereby equipment or components both in the faulty feeder as well as in other parts of the galvanically interconnected electrical network can be protected against harmful overvoltage or overcurrent. After the fault has been cleared, the disconnected feeder may again be connected to the busbar BB by closing the specific circuit breaker.

The electrical network EN further comprises a first intelligent electronic device IED1 configured to control the operation of the first circuit breaker CB1 through a control line CL1, and a second intelligent electronic device IED2 configured to control the operation of the second circuit breaker CB2 through a control line CL2. The intelligent electronic devices IED1 and IED2 are configured to measure, through measurement instruments MI1 and M12, quantities of the electrical network EN, such as phase voltages U and phase currents I prevailing in the specific feeder. The intelligent electronic devices may also be configured to determine other quantities of the electrical network EN, such as frequency of the network or power flowing in the feeder, on the basis of the measured quantities of the electrical network EN, and/or whether or not a fault exists on the corresponding feeder. If at least one of the intelligent electronic devices IED1 or IED2 indicates that a fault exists on the corresponding feeder, the specific intelligent electronic device sends to the corresponding circuit breaker through the control line a control signal for opening the corresponding circuit breaker, thus preventing power supply to the corresponding feeder. After a predetermined elapsed time, the specific intelligent electronic device may send to the corresponding circuit breaker through the control line a new control signal for closing the corresponding circuit breaker, thus restoring the power supply to the feeder.

The intelligent electronic devices IED1 and IED2 may for example comprise a microprocessor or a signal processor and possibly one or more memory units to run or execute a software program code for carrying out the sampling of the quantities to be measured in the electrical network, such as phase voltages and phase currents, and to carry out necessary computation for the determination of the further quantities of the electrical network EN, as well as to determine whether or not a fault exists in the protected zone of the specific intelligent electronic device.

The intelligent electronic devices IED1, IED2 and IED3 are connected to the electric station computer ESC through wired or wireless communication channels COM1 and COM2, so that the intelligent electronic devices IED1 and IED2 may send information to the electric station computer ESC and/or receive information or control commands from the electric station computer ESC.

The electricity network EN of Figure 1 further comprises, in a last part F2" of the second feeder F2, a recloser R which can be used to connect the last part F2" of the second feeder F2 to a first part F2' of the second feeder F2, or to disconnect the last part F2" of the second feeder F2 from the first part F2' of the second feeder F2. The operation of the recloser R is controlled by means of a control device CD, which is connected to the recloser R through a control line CL3. The operation of the control device CD is, in turn, controlled by means of the first intelligent electronic device IED1, which is connected to the control device CD through a wired or wireless communication channel COM3, whereby the first intelligent electronic device IED1 is configured to send the control device CD a control signal for opening or closing the recloser R. Alternatively, the electric station computer ESC could be connected to the control device CD, whereby the electric station computer ESC would be connected to the control device CD through the communication channel COM3 for controlling the operation of the recloser R.

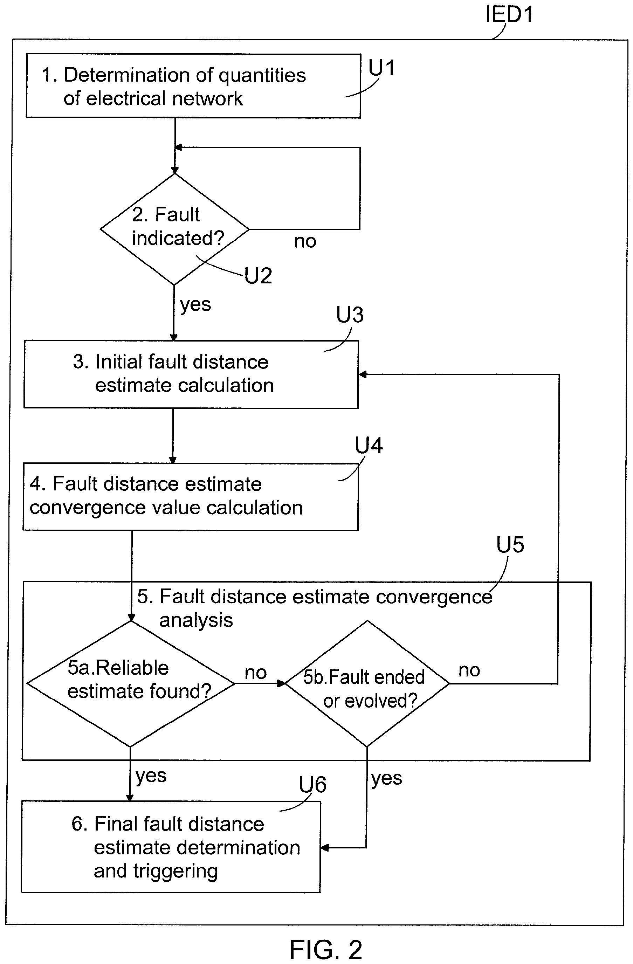

In the following, referring to Figure 2, it is disclosed a method and a system for determining, as an integral part of a fault distance estimation operation or application, an optimal moment for performing a triggering for recording at least one initial fault distance estimate $ide_f$ and/or at least one final fault distance estimate $fde_f$ for a fault appearing in the electrical network EN. The initial fault distance estimates $ide_f$ and the final fault distance estimate $fde_f$ represent an estimate for the actual fault distance $d_f$ between the fault location FL in the network and the position of the network at which the measurement of necessary quantities of the electrical network takes place. The method and the system is presented referring to a fault appearing in the second feeder F2 representing a medium voltage distribution feeder, and it is assumed that the fault appears behind the recloser R, i.e. in relation to the recloser R on that side of the recloser R which is opposite to the side where the electric station ES is located. The fault location FL in the feeder F2 is denoted by reference sign FL in Figure 1. The method and the system are correspondingly implementable also for faults appearing in the third feeder F3 of Figure 1 or in other kinds of medium voltage distribution networks the structure or configuration of which may deviate from that shown in Figure 1. Figure 2 discloses a schematic representation of the main steps of the method in a form of a flow diagram. In the example below it is assumed that all the operations and equipment for carrying out the method is provided by the first intelligent electronic device IED1.

In the method step referred to by reference number 1 in Figure 2, different quantities of the electrical network EN needed for the detection of the fault and for the determination of the fault distance estimates are determined. Corresponding means or unit for carrying out the method step is schematically shown by a box denoted with reference sign U1. This method step includes at least a substantially continuous measurement of those quantities of the electrical network EN which are necessary for the detecting a fault and/or for the determination of the fault distance estimates for that fault. The substantially continuous measurement refers to using in the measurement a sampling rate high enough for allowing reliable measurements of the specific quantities of the electrical network EN. Typically the measured quantities of the electrical network EN are phase voltages U and phase currents I of the specific feeder at the corresponding circuit breaker, thus, in this example phase voltages U and phase currents I of the second feeder F2 at the first circuit breaker CB1. The unit U1 thus comprises a necessary amount of sampling elements for sampling the quantities to be measured. The actual measurement of the quantities to be measured is provided by the measurement instrument MI1 at the first circuit breaker CB1. If the measurement instrument MI1 comprises the sampling elements, the unit U1 may comprise only equipment for receiving the samples from the measurement instrument MI1.

In the method step referred to by reference number 2 in Figure 2, a fault detection procedure is carried out. In the fault detection procedure it is determined, by analysing the sampled quantities of the electrical network, whether or not a fault exists in the second feeder F2. There are several faults which may appear in the electrical network, such as different short-circuit faults and phase-to-earth faults. If no fault is indicated, the fault detection procedure is carried out again on the basis of the following new samples of the quantities of the electrical network. If a fault is indicated, a fault distance estimation procedure, presented in the method step referred to by reference number 3 in Figure 2, is activated. The fault detection procedure may be carried out for example by a microprocessor, a signal processor or another suitable processor utilizing possibly also one or more memory units to run or execute a software program code for fault detection analysis. This equipment is presented in Figure 2 very schematically by a box denoted with reference sign U2. The fault detection procedure is typically carried out substantially continuously, meaning that the fault detection procedure is repeated every time when new samples of the specific quantities of the electrical network are available.

In the method step referred to by reference number 3 in Figure 2, an initial fault distance estimate $ide_f$ calculation is carried out. In this method step, a number of successive initial fault distance estimates $ide_f$ providing estimates for the actual fault distance $d_f$, i.e. in Figure 1, a distance $d_f$ between the fault location FL and the position of the measurement instrument MI1, are calculated continuously at successive time instants by using the measured quantities of the electrical network EN, such as one or more phase voltages and phase currents. The fault distance estimation procedure is initiated in response to the detected fault. The fault distance estimation procedure is preferably started immediately when the fault is detected. The fault distance estimation procedure is carried out substantially continuously, meaning that a new initial estimate $ide_f$ for the fault distance is determined every time when new samples of the specific quantities of the electricity network are available during the fault. The initial fault distance estimates $ide_f$ may preferably be expressed by the per unit feeder length scaling but also some absolute scaling such as kilometres, metres or miles may be used. The initial fault distance estimates $ide_f$ and a convergence parameter presented later are expressed in the same scaling so as to allow their comparison, as described later in this specification.

Some other appropriate scaling may also be used.

Any kind of fault distance estimation methods may be used for calculating the initial fault distance estimates. An example of a method for fault distance estimation, which may be used in this solution, is disclosed in US-publication 2006/0291113 A1. The fault distance estimation procedure of method step 3 may be carried out for example by a microprocessor, a signal processor or another suitable processor utilizing possibly also one or more memory units to run or execute a software program code for fault distance estimation. This equipment is presented in Figure 2 only very schematically by a box denoted with reference mark U3.

In the method step referred to by reference number 4 in Figure 2, a divergence analysis or comparison of successive initial fault distance estimates is carried out. In this method step a convergence value cv for a sequence of successive initial fault distance estimates $ide_f$ is provided, which convergence value cv provides a measure describing the divergence or difference of the calculated initial fault distance estimates $ide_f$ from its latest value. The convergence value cv thus provides a measure of a stabilization of the successive initial fault distance estimates $ide_f$. Later, in the method step referred to by reference number 5, the convergence value cv is utilized to determine whether a sufficiently stable estimate for the fault distance has been achieved.

According to an embodiment the $i_{th}$ convergence value cv can be calculated with a formula

$$cv = \max_{k=1 ..n} \left| ide_f(i) - ide_f(i\text{-}k) \right|,$$

where n is the number of estimates available. In this embodiment the convergence value cv thus describes an absolute value of a maximum difference of the latest initial fault distance estimate $ide_f$ from the other initial fault distance estimates $ide_f$ for a sequence comprising altogether n pieces of initial fault distance estimates $ide_f$. There is no need to begin k from zero due to inherent reasons although it can also be included in the calculation, if desired. Later, in method step referred to by reference number 5, for determining the stability of the initial fault distance estimates the convergence value cv is compared with an allowable variation of the latest initial fault distance estimate for a sequence, which is determined by a convergence parameter cp. The equation above inherently deduces the convergence parameter cp to be given as a positive value.

According to an embodiment, the convergence parameter cp is a settable parameter which provides a limit value describing the maximum allowable variation around the latest initial fault distance estimate $ide_f$ and a sequence of the initial fault distance estimates $ide_f$. The convergence parameter cp may be defined as a relative value to the feeder line length, for example in per cents, or per unit length so that it is always given in the same scale as the calculated convergence value cv. Alternatively, the convergence parameter cp may also be given as an absolute value, such as kilometres, metres or miles following the same principle as with the convergence value cv.

The determination of the convergence value cv is carried out for example by a microprocessor, a signal processor or another suitable processor utilizing possibly also one or more memory units to run or execute a specific software program code for carrying out the method step. This equipment is presented in Figure 2 only very schematically by a box denoted with reference sign U4.

According to an embodiment, the successive initial fault distance estimates $ide_f$ are filtered, for example mean value averaged, and this filtered value provides a convergence value cv, which is utilized to determine whether a sufficiently stable fault distance estimate has been achieved. Of course, certain kind of filtering already at that phase can also have a non-beneficial impact to rapid estimate stabilization and therefore at least some weighting may be included in that filtering.

In the method step referred to by reference number 5 in Figure 2 it is determined if a sufficiently stable fault distance estimate has been achieved. In this method step the convergence value cv is compared with the convergence parameter cp. The convergence parameter cp may be different for different kinds of faults, i.e. there may be separate settings for each different fault type, or one setting parameter may be adapted to different fault types by internal multiplication. For example, the convergence parameter cp may be for example 1.5% for short-circuit faults and 4.5% (referring to internal parameter multiplication by three) for phase-to-earth faults.

In the method step 5 two operations have been disclosed. In the first operation, referred to by the reference sign 5a in Figure 2, the convergence value cv is compared to the convergence parameter cp for determining whether the convergence value cv fulfills the condition set by the convergence parameter cp for the stability of the initial fault distance estimates, i.e. whether the convergence value cv is equal to or smaller than the convergence parameter cp set for the fault distance estimation. In other words, in this method step the validity of the formula

$$cv \leq cp$$

is inspected. In this operation, it may be determined that a sufficiently stable fault distance estimate has been achieved when the convergence value cv for the first time fulfils the condition set by the convergence parameter cp, and the method may proceed to a next method step, i.e. to a method step referred to by a reference number 6, where the triggering for recording at least one fault distance estimate is provided.

If the first operation 5a provides a result that the convergence value cv still exceeds the convergence parameter cp, meaning that a sufficiently stable fault distance estimate has not yet been achieved, a second operation denoted by reference sign 5b is performed. In this second operation it is verified whether a fault has disappeared, i.e. ended, or evolved or if the fault continues as such.

If the fault has disappeared, the method proceeds to the next method step, i.e. to the method step 6, because the fault has ended and it is no longer possible to receive new samples of the quantities of the electrical network that would describe the fault situation. Some field tests have shown that there may be a short evolving fault period due to a fault end signal transient but this phenomenon may also have some dependency on the chosen calculation algorithm. Although this fault end transient results to a fault type change, it may be more important to provide a triggering for recording the fault distance estimate from the original fault type. On the other hand, the fault end transient with a different fault loop indication is typically so short that there is no reason to provide the triggering for that short evolving fault at all, or perhaps no stabilized fault distance estimate can be achieved anymore from this fault end transient.

If the fault has evolved, meaning that the fault type has changed for example from a two-phase short-circuit fault to a three-phase short-circuit fault, the change of the fault type causes a calculation algorithm change, because typically there are separate calculation algorithms for different fault types, and possibly an abrupt change on the initial fault distance estimate. For evolving fault it may be arranged to be dependent on the architecture design, if fault distance estimation begins anew with a new fault type without a triggering, or with a triggering of the earlier fault type, and proceeds to the step 6 in Figure 2. However, if there is plenty of recording memory available, it is possible to provide the triggering for recording both the original and evolving faults especially for permanent or long-time evolving faults, where possibly also this new fault distance estimate oscillation will settle down what causes the triggering. But this is more or less of an architecture design decision based on available computation capacity.

If the fault continues, the method returns to the method step number 3 and a new initial fault distance estimate $ide_f$ is calculated on the basis of new samples of the quantities of the electrical network. After that a new convergence value cv calculation and the convergence or divergence analysis described above is performed again.

The operations disclosed in the method step 5 are carried out in a unit comprising for example a microprocessor, a signal processor or another suitable processor utilizing possibly also one or more memory units to run or execute a specific software program code for carrying out this method step. This unit or equipment is presented in Figure 2 only very schematically by a box denoted with reference sign U5.

In the method step referred to by reference number 6 in Figure 2 it is provided the triggering for recording at least one fault distance estimate.

According to an embodiment of the method step 6, if the convergence value cv has not fulfilled the condition set by the convergence parameter cp and the fault has disappeared or evolved, the triggering may be provided for recording only the latest initial fault distance estimate $ide_f$ which may then also be defined to be the final fault distance estimate $fde_f$.

According to another embodiment of the method step 6, if the convergence value cv has not fulfilled the condition set by the convergence parameter cp and the fault has disappeared or evolved, the final fault distance estimate $fde_f$ is computed as a filtered value of a sequence of the initial fault distance estimates $ide_f$. The sequence of the initial fault distance estimates may comprise for example the initial fault distance estimates calculated during the latest full cycle of the fundamental frequency of the electrical network.

According to an embodiment, if the convergence value cv has fulfilled the condition set by the convergence parameter cp, the triggering for recording only the latest initial fault distance estimate $ide_f$ may be provided or the triggering for recording a filtered value of the sequence of initial fault distance estimates $ide_f$ calculated during the latest full cycle of the fundamental frequency of the electrical network, for example, may be provided. According to an embodiment the filtered value may be for example a mean value of the successive initial fault distance estimates $ide_f$ calculated during the latest full cycle of the fundamental frequency of the electrical network. It should, however, be noticed that the initial fault distance estimate determination and the convergence analysis may be continued as long as the fault continues, although the triggering for recording at least one fault distance estimate is already provided, whereby new initial and final fault distance estimates are provided and may be recorded as long as the fault continues.

According to an embodiment, it is also possible that a sufficiently stable fault distance estimate is frozen to the output so that it is possible to provide the triggering for this then during the fault end with a pre-defined triggering moment. However, this embodiment does not propose the fastest possible response and it is also possible that even a better estimate can be achieved if a later estimate during the continued calculation will be triggered.

According to an embodiment, if the fault has lasted for a very short time such that only some initial fault distance estimates $ide_f$ are calculated before the fault has disappeared, it is typically not worth providing any triggering from such an uncertain estimate. However, if a large recording capacity is available, the final fault distance estimate $fde_f$ may be determined to be the single initial fault distance estimate $ide_f$ calculated or a filtered value of a sequence of the initial fault distance estimates $ide_f$ calculated. Particularly in that case but also generally a quality value may be provided for the operator as a measure of the stability and reliability of the disclosed final fault distance estimate $fde_f$.

The operations for providing the triggering for recording the one or more initial fault distance estimates and/or only the final fault distance estimate $fde_f$, in response to the progress of the fault distance estimate determination, are carried out in a unit comprising for example a microprocessor, a signal processor or another suitable processor utilizing possibly also one or more memory units to run or execute a specific software program code for carrying out this method step. This unit or equipment is presented in Figure 2 only very schematically by a box denoted by reference sign U6.

In the example presented above the method steps 1 to 6 are each carried out in specific separate equipment or units U1 to U6, but it is of course possible that there is only one equipment or unit comprising for example a microprocessor, a signal processor or another suitable processor and also possibly one or more memory units to run or execute specific software program codes for carrying out all the method steps presented.

In the example of Figure 2 and the relating description it was assumed that all the operations were carried out by the intelligent electronic device IED1, wherefore in Figure 2 all the methods steps and units or equipment are schematically surrounded by a box denoted with reference sign IED1. However, if a device corresponding to the intelligent electronic device 1 would not exist, the necessary operations could be carried out for example by the electric station computer ESC, whereby the electric station computer ESC would comprise one or more units or equipment for carrying out the operations needed. It is also possible to have an embodiment where some of the operations needed may be carried out by the intelligent electronic device IED1 and some other operations by the electric station computer ESC.

In the solution presented, the triggering for recording at least one fault distance estimate takes place on-line on the basis of the progress of the fault distance estimation procedure or application, whereas in prior art methods the quantities of electrical network are measured and stored into a storage medium during the fault, but any further actions for fault distance calculation and possible determination of a reliability of the estimated fault distance are executed off-line after the fault. Alternatively, in the prior art, the triggering of the fault distance estimate is done in a pre-defined manner by an external triggering signal provided by an external application so that fault distance estimate calculation itself is not a factor affecting the correct estimate triggering moment. In this prior-art case it is thus possible that the triggering is done too early, resulting in a rather uncertain estimate or the triggering is done too late so that the estimate is no more available at all or it is slower than it could be and by that jeopardizes power network maintenance. In that kind of prior art solutions, wherein the triggering is provided by an external application, it is also possible that the external application does not provide any triggering at all if the duration of the fault is shorter than the operating time of that application.

In the solution disclosed above, the fault distance estimation is carried out on-line or in real-time during the time the fault is present in the feeder, whereby the value of the final fault distance estimate $fde_f$ may be obtained already before any protective operations against the fault must be started, or, alternatively, there is no need to purposefully maintain the fault in the network for fault location purposes, and the operations for removing the fault can be started earlier than provided by a current practice. It is also possible that it may be the recloser R and not the first circuit breaker CB1 which is opened, when the fault distance estimation procedure provides a final fault distance estimate $fde_f$, which states that the fault location is behind the recloser R as seen from the electric station ES, as shown in the example of Figure 1. Thereby the power may be disconnected only from the last part F2" of the second feeder F2 but not from the first part F2' of the feeder F2 also, as it has to be done presently. This means that the first intelligent electronic device IED1 may send a control signal to the control device CD for opening the recloser R instead of providing the control signal to open the first circuit breaker CB1. However, if a delay for opening the recloser R is too long so that the first circuit breaker CB1 must in any case be opened, the information provided by the final fault distance estimate $fde_f$ may be utilized such that the first circuit breaker CB1 is opened first and after the first circuit breaker CB1 has been opened, the recloser R is opened as soon as possible, whereby the first circuit breaker can be closed again for returning the power supply to the first part F2' of the second feeder F2.

The solution disclosed here provides a fast and reliable fault distance estimate triggering. The method also provides that a fault distance estimate is available even for short faults not resulting to protective operations, in which case the recorded fault distance estimate provides information about the fault location so that preventive actions for a possibly weak power network may be started before the fault evolves to a permanent fault.

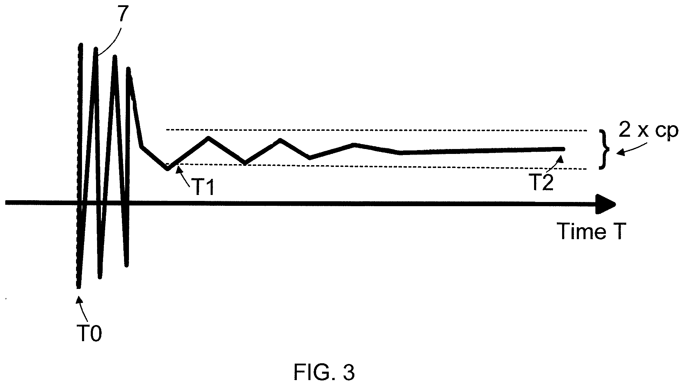

Figure 3 discloses schematically an example of a typical behaviour of a fault distance estimate in time, where a curve 7 describes successive initial fault distance estimates $ide_f$. Figure 3 discloses further by dotted straight lines limits defined by a convergence parameter cp describing the maximum allowable variation of the latest initial fault distance estimate $ide_f$ for a sequence between time instants T1 and T2, the convergence parameter cp thus providing limits between which the initial fault distance estimates $ide_f$ in a sequence should remain so that the the initial fault distance estimate $ide_f$ can be considered to be stabilized so that the initial fault distance estimate has reached a value that can be filtered to be the final value, which is close to the actual fault distance $d_f$. When studying Figure 3, we notice that dotted lines refer to the latest initial fault distance estimate $ide_f$ at time instant T2. In other words, the limits defined by the dotted lines are always related to the latest initial fault distance estimate $ide_f$ so that the upper limit is "the latest initial fault distance estimate $ide_f$ + cp" and the lower limit is "the latest initial fault distance estimate $ide_f$ - cp" resulting to a maximum allowed variation being two times the convergence parameter cp.

In the example of Figure 3 the fault begins at time instant T0, at which the fault is indicated and the fault distance estimate computation is started. At the beginning of the fault the quantities of the electrical network used in the calculation of the initial fault distance estimates $ide_f$ comprises initial transients, this being the reason why the successive initial fault distance estimates $ide_f$ vary significantly at the beginning of the fault. After the initial transients are damped, the initial fault distance estimates $ide_f$ start to settle down and remain in the range defined by the convergence parameter cp. At time instant T2 it can be stated that the time instant T1 indicates the moment at which the initial fault distance estimate $ide_f$ for the first time remained between the limits defined by the initial fault distance estimate $ide_f$ and convergence parameter cp at time instant T2 and the triggering for recording the fault distance estimate may then be provided at time instant T2, the time instant T2 thus being the triggering moment for recording the fault distance estimate. In other words, at time instant T2 it is determined that the initial fault distance estimates $ide_f$ have remained in the range so long that a sufficiently stable fault distance estimate has been achieved and the final fault distance estimate $de_f$ may be provided. The time period between the time instants T1 and T2 may be for example a half cycle or a full cycle of the fundamental frequency of the electrical network. This dependency to fundamental frequency cycle can be beneficial because possible final estimate averaging inherently filters initial estimate oscillation around final value. However, this period length may be freely chosen based on distance estimation algorithm characteristics and it effectively also defines the number of successive initial fault distance estimates $ide_f$ to be taken into the calculation sequence. The final fault distance estimate $fde_f$ may be for example the initial fault distance estimate $ide_f$ at time instant T2 or a filtered value of the initial fault distance estimates $ide_f$ between the time instants T1 and T2.

According to an embodiment some weighting factor filtering for output can be done, meaning for example that the newer initial fault distance estimates $ide_f$ are weighted more than the older ones on the basis of the assumption that the newer initial fault distance estimates $ide_f$ are more reliable than the older ones.

According to an embodiment, the final fault distance estimate $fde_f$ can be frozen so that it can be triggered also at a later stage during fault. Also it is possible to keep the final fault distance estimate $fde_f$ frozen even after fault removal, but in that case a freezing removal scheme has to be arranged so that new fault distance estimation is again possible for next fault occurrence.

It will be obvious to a person skilled in the art that, as technology advances, the inventive concept can be implemented in various ways. The invention and its embodiments are not limited to the examples described above but may vary within the scope of the claims.

In the example disclosed above, the solution for determining fault distance estimate triggering is shown in connection with a medium voltage distribution network, but the solution may be used also in high voltage transmission networks or in low voltage networks, if there are suitable equipment available for measuring the necessary quantities of the electrical network as well as for determining the fault distance estimate.

## Claims

1. A method for triggering a recording of a fault distance estimate in an electrical network (EN), the method comprising
detecting a fault in the electrical network (EN),
**characterized by** further comprising
determining, in response to the detection of the fault, at least a number of successive initial fault distance estimates ($ide_f$) continuously during the presence of the fault,
determining continuously successive convergence values (cv) for sequences of successive initial fault distance estimates ($ide_f$), wherein the convergence value (cv) is an absolute value of a maximum difference of the latest initial fault distance estimate ($ide_f$) from the other initial fault distance estimates ($ide_f$) in the sequence of the successive initial fault distance estimates ($ide_f$),
comparing the convergence values (cv) to a condition set by a convergence parameter (cp) for a stability of the initial fault distance estimates ($ide_f$), wherein the convergence parameter (cp) is a settable parameter describing the maximum allowable variation around the latest initial fault distance estimate ($ide_f$), and
recording the at least one fault distance estimate ($ide_f$, $fde_f$) in response to the at least one convergence value (cv) fulfilling the condition set by the convergence parameter (cp), wherein the fault distance estimate to be recorded comprises a latest initial fault distance estimate ($ide_f$) or a final fault distance estimate ($fde_f$) representing a filtered value of a sequence of initial fault distance estimates ($ide_f$).

2. A method as claimed in claim 1, wherein the triggering for recording the at least one fault distance estimate ($ide_f$, $fde_f$) is performed in response to a disappearance of the fault if no recording of the fault distance estimate ($ide_f$, $fde_f$) for the fault has been triggered yet.

3. A method as claimed in claim 1 or 2, wherein

the triggering for recording the at least one fault distance estimate ($ide_f$, $fde_f$) is performed in response to a change in a fault type if no recording of the fault distance estimate ($ide_f$, $fde_f$) for the fault has been triggered yet.

4. A method as claimed in claim 1, comprising determining the final fault distance estimate ($fde_f$) as a filtered value of the sequence of the successive initial fault distance estimates ($ide_f$).

5. A system for triggering a recording of a fault distance estimate in an electrical network (EN), the system comprising
   means for detecting a fault in the electrical network (EN),
   **characterized in that** the system further comprises
   means for determining continuously, in response to the detection of the fault, at least a number of successive initial fault distance estimates ($ide_f$) during the presence of the fault,
   means for determining continuously successive convergence values (cv) for sequences of the successive initial fault distance estimates ($ide_f$), wherein the convergence value (cv) is an absolute value of a maximum difference of the latest initial fault distance estimate ($ide_f$) from the other initial fault distance estimates ($ide_f$) in the sequence of the successive initial fault distance estimates ($ide_f$),
   means for comparing the convergence values (cv) to a condition set by a convergence parameter (cp) for a stability of the initial fault distance estimates ($ide_f$), wherein the convergence parameter (cp) is a settable parameter describing the maximum allowable variation around the latest initial fault distance estimate ($ide_f$), and
   means for triggering of the recording of the at least one fault distance estimate ($ide_f$, $fde_f$) in response to at least one convergence value (cv) fulfilling the condition set by the convergence parameter (cp), wherein the fault distance estimate to be recorded comprises a latest initial fault distance estimate ($ide_f$) or a final fault distance estimate ($fde_f$) representing a filtered value of a sequence of initial fault distance estimates ($ide_f$).

6. A system as claimed in claim 5, comprising means for performing the triggering for recording the at least one fault distance estimate ($ide_f$, $fde_f$) in response to a disappearance of the fault if no fault distance estimate ($ide_f$, $fde_f$) for the fault has been recorded yet.

7. A system as claimed in claim 5 or 6, comprising means for performing the triggering for recording the at least one fault distance estimate ($ide_f$, $fde_f$) in response to a change in a fault type if no fault distance estimate ($ide_f$, $fde_f$) for the fault has been recorder yet.

8. A system as claimed in claim 5, comprising means for determining a final fault distance estimate ($fde_f$) as a filtered value of a sequence of the successive initial fault distance estimates ($ide_f$).

**Patentansprüche**

1. Verfahren zum Auslösen der Aufzeichnung einer Schätzung der Fehlerentfernung in einem elektrischen Netz (EN), wobei das Verfahren umfasst:

   Erkennen eines Fehlers in dem elektrischen Netz (EN),
   **dadurch gekennzeichnet, dass** es weiter umfasst:

   Fortlaufendes Ermitteln, als Reaktion auf die Erkennung des Fehlers, zumindest einer Anzahl von aufeinanderfolgenden anfänglichen Schätzungen der Fehlerentfernung ($ide_f$) während des Vorhandenseins des Fehlers,
   Fortlaufendes Ermitteln aufeinanderfolgender Konvergenzwerte (cv) für Sequenzen von aufeinanderfolgenden anfänglichen Schätzungen der Fehlerentfernung ($ide_f$), wobei der Konvergenzwert (cv) ein absoluter Wert einer maximalen Differenz zwischen der neuesten anfänglichen Schätzung der Fehlerentfernung ($ide_f$) und den anderen anfänglichen Schätzungen der Fehlerentfernung ($ide_f$) in der Sequenz der aufeinanderfolgenden anfänglichen Schätzungen der Fehlerentfernung ($ide_f$) ist,
   Vergleichen der Konvergenzwerte (cv) mit einer durch einen Konvergenzparameter (cp) für eine Stabilität der anfänglichen Schätzungen der Fehlerentfernung ($ide_f$) festgelegten Bedingung, wobei der Konvergenzparameter (cp) ein einstellbarer Parameter ist, der die maximal zulässige Abweichung von der neuesten anfänglichen Schätzung der Fehlerentfernung ($ide_f$) beschreibt, und
   Aufzeichnen der zumindest einen Schätzung der Fehlerentfernung ($ide_f$, $fde_f$) als Reaktion auf den zumindest einen Konvergenzwert (cv), der die durch den Konvergenzparameter (cp) festgelegte Bedingung erfüllt, wobei die aufzuzeichnende Schätzung der Fehlerentfernung eine neueste anfängliche Schätzung der Fehlerentfernung ($ide_f$) oder eine endgültige Schätzung der Fehlerentfernung ($fde_f$) umfasst, welche einen gefilterten Wert einer Sequenz von anfänglichen Schätzungen der Fehlerentfernung ($ide_f$) darstellt.

2. Verfahren nach Anspruch 1, wobei die Auslösung zur Aufzeichnung der zumindest einen Schätzung der Fehlerentfernung ($ide_f$, $fde_f$) als Reaktion auf ein Verschwinden des Fehlers erfolgt, wenn noch keine Aufzeichnung der Schätzung der Fehlerentfernung ($ide_f$, $fde_f$) für den Fehler ausgelöst wurde.

3. Verfahren nach Anspruch 1 oder 2, wobei die Auslösung zur Aufzeichnung der zumindest einen Schätzung der Fehlerentfernung ($ide_f$, $fde_f$) als Reaktion auf eine Änderung eines Fehlertyps erfolgt, wenn noch keine Aufzeichnung der Schätzung der Fehlerentfernung ($ide_f$, $fde_f$) für den Fehler ausgelöst wurde.

4. Verfahren nach Anspruch 1 umfassend das Ermitteln der endgültigen Schätzung der Fehlerentfernung ($fde_f$) als gefilterter Wert der Sequenz der aufeinanderfolgenden anfänglichen Schätzungen der Fehlerentfernung ($ide_f$).

5. System zum Auslösen einer Aufzeichnung einer Schätzung der Fehlerentfernung in einem elektrischen Netz (EN), wobei das System umfasst:

Mittel zum Erkennen eines Fehlers in dem elektrischen Netzwerk (EN),
**dadurch gekennzeichnet, dass** das System weiter umfasst:

Mittel zum fortlaufenden Ermitteln, als Reaktion auf die Erkennung des Fehlers, zumindest einer Anzahl von aufeinanderfolgenden anfänglichen Schätzungen der Fehlerentfernung ($ide_f$) während des Vorhandenseins des Fehlers,
Mittel zum fortlaufenden Ermitteln aufeinanderfolgender Konvergenzwerte (cv) für Sequenzen von aufeinanderfolgenden anfänglichen Schätzungen der Fehlerentfernung ($ide_f$), wobei der Konvergenzwert (cv) ein absoluter Wert einer maximalen Differenz zwischen der neuesten anfänglichen Schätzung der Fehlerentfernung ($ide_f$) und den anderen anfänglichen Schätzungen der Fehlerentfernung ($ide_f$) in der Sequenz der aufeinanderfolgenden anfänglichen Schätzungen der Fehlerentfernung ($ide_f$) ist,
Mittel zum Vergleichen der Konvergenzwerte (cv) mit einer durch einen Konvergenzparameter (cp) für eine Stabilität der anfänglichen Schätzungen der Fehlerentfernung ($ide_f$) festgelegten Bedingung, wobei der Konvergenzparameter (cp) ein einstellbarer Parameter ist, der die maximal zulässige Abweichung von der neuesten anfänglichen Schätzung der Fehlerentfernung ($ide_f$) beschreibt, und
Mittel zum Auslösen der Aufzeichnung der zumindest einen Schätzung der Fehlerentfernung ($ide_f$, $fde_f$) als Reaktion auf den zumindest einen Konvergenzwert (cv), der die durch den Konvergenzparameter (cp) festgelegte Bedingung erfüllt, wobei die aufzuzeichnende Schätzung der Fehlerentfernung eine neueste anfängliche Schätzung der Fehlerentfernung ($ide_f$) oder eine endgültige Schätzung der Fehlerentfernung ($fde_f$) umfasst, welche einen gefilterten Wert einer Sequenz von anfänglichen Schätzungen der Fehlerentfernung ($ide_f$) darstellt.

6. System nach Anspruch 5 umfassend:
Mittel zum Ausführen der Auslösung zur Aufzeichnung der zumindest einen Schätzung der Fehlerentfernung ($ide_f$, $fde_f$) als Reaktion auf ein Verschwinden des Fehlers, wenn noch keine Schätzung der Fehlerentfernung ($ide_f$, $fde_f$) für den Fehler aufgezeichnet wurde.

7. System nach Anspruch 5 oder 6 umfassend:
Mittel zum Ausführen der Auslösung zur Aufzeichnung der zumindest einen Schätzung der Fehlerentfernung ($ide_f$, $fde_f$) als Reaktion auf eine Änderung des Fehlertyps, wenn noch keine Schätzung der Fehlerentfernung ($ide_f$, $fde_f$) für den Fehler aufgezeichnet wurde.

8. System nach Anspruch 5 umfassend:
Mittel zum Ermitteln einer endgültigen Schätzung der Fehlerentfernung ($fde_f$) als gefilterter Wert einer Sequenz der aufeinanderfolgenden anfänglichen Schätzungen der Fehlerentfernung ($ide_f$).

**Revendications**

1. Procédé de déclenchement d'un enregistrement d'une estimation de distance de panne dans un réseau électrique (EN), le procédé comprenant la détection d'une panne dans le réseau électrique (EN),
**caractérisé en ce qu'**il comprend en outre la détermination, en réponse à la détection de la panne, d'au moins un certain nombre d'estimations successives de distance de panne initiale ($ide_f$) en continu pendant la présence de la panne, la détermination en continu de valeurs de convergence successives (cv) pour des séquences d'estimations successives de distance de panne initiale (ide$_f$), dans lequel la valeur de convergence (cv) est une valeur absolue d'une différence maximale de la dernière estimation de distance de panne initiale (ide$_f$) par rapport aux autres estimations de distance de panne initiale (ide$_f$) dans la séquence des estimations successives de distance de panne initiale (ide$_f$),

la comparaison des valeurs de convergence (cv) à une condition réglée par un paramètre de convergence (cp) pour une stabilité des estimations de distance de panne initiale (ide$_f$), dans lequel le paramètre de convergence (cp) est un paramètre réglable décrivant la variation maximale admissible autour de la dernière estimation de distance de panne initiale (ide$_f$), et

l'enregistrement de l'au moins une estimation de distance de panne (ide$_f$, fde$_f$) en réponse à l'au moins une valeur de convergence (cv) remplissant la condition réglée par le paramètre de convergence (cp), dans lequel l'estimation de distance de panne à enregistrer comprend une dernière estimation de distance de panne initiale (ide$_f$) ou une estimation de distance de panne finale (fde$_f$) représentant une valeur filtrée d'une séquence d'estimations de distance de panne initiale (ide$_f$).

2. Procédé tel que revendiqué dans la revendication 1, dans lequel
le déclenchement de l'enregistrement de l'au moins une estimation de distance de panne (ide$_f$, fde$_f$) est effectué en réponse à une disparition de la panne si aucun enregistrement de l'estimation de distance de panne (ide$_f$, fde$_f$) pour la panne n'a encore été déclenché.

3. Procédé tel que revendiqué dans la revendication 1 ou 2, dans lequel
le déclenchement de l'enregistrement de l'au moins une estimation de distance de panne (ide$_f$, fde$_f$) est effectué en réponse à une modification dans un type de panne si aucun enregistrement de l'estimation de distance de panne (ide$_f$, fde$_f$) pour la panne n'a encore été déclenché.

4. Procédé tel que revendiqué dans la revendication 1, comprenant la détermination de l'estimation de distance de panne finale (fde$_f$) en tant que valeur filtrée de la séquence des estimations successives de distance de panne initiale (ide$_f$).

5. Système de déclenchement d'un enregistrement d'une estimation de distance de panne dans un réseau électrique (EN), le système comprenant
un moyen pour détecter une panne dans le réseau électrique (EN),
**caractérisé en ce que** le système comprend en outre
un moyen pour déterminer en continu, en réponse à la détection de la panne, au moins un certain nombre d'estimations successives de distance de panne initiale (ide$_f$) pendant la présence de la panne,
un moyen pour déterminer en continu des valeurs de convergence successives (cv) pour des séquences des estimations successives de distance de panne initiale (ide$_f$), dans lequel la valeur de convergence (cv) est une valeur absolue d'une différence maximale de la dernière estimation de distance de panne initiale (ide$_f$) par rapport aux autres estimations de distance de panne initiale (ide$_f$) dans la séquence des estimations successives de distance de panne initiale (ide$_f$),
un moyen pour comparer les valeurs de convergence (cv) à une condition réglée par un paramètre de convergence (cp) pour une stabilité des estimations de distance de panne initiale (ide$_f$), dans lequel le paramètre de convergence (cp) est un paramètre réglable décrivant la variation maximale admissible autour de la dernière estimation de distance de panne initiale (ide$_f$), et
un moyen pour déclencher l'enregistrement de l'au moins une estimation de distance de panne (ide$_f$, fde$_f$) en réponse à au moins une valeur de convergence (cv) remplissant la condition réglée par le paramètre de convergence (cp), dans lequel l'estimation de distance de panne à enregistrer comprend une dernière estimation de distance de panne initiale (ide$_f$) ou une estimation de distance de panne finale (fde$_f$) représentant une valeur filtrée d'une séquence d'estimations de distance de panne initiale (ide$_f$).

6. Système tel que revendiqué dans la revendication 5, comprenant
un moyen pour effectuer le déclenchement de l'enregistrement de l'au moins une estimation de distance de panne (ide$_f$, fde$_f$) en réponse à une disparition de la panne si aucune estimation de distance de panne (ide$_f$, fde$_f$) pour la panne n'a encore été enregistrée.

7. Système tel que revendiqué dans la revendication 5 ou 6, comprenant
un moyen pour effectuer le déclenchement de l'enregistrement de l'au moins une estimation de distance de panne (ide$_f$, fde$_f$) en réponse à une modification dans un type de panne si aucune estimation de distance de panne (ide$_f$, fde$_f$) pour la panne n'a encore été enregistrée.

8. Système tel que revendiqué dans la revendication 5, comprenant
un moyen pour déterminer une estimation de distance de panne finale (fde$_f$) en tant que valeur filtrée d'une séquence des estimations successives de distance de panne initiale (ide$_f$).

FIG. 1

EP 2 884 291 B1

IED1

FIG. 2

FIG. 3

**EP 2 884 291 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011184673 A1
- JP S5950373 A
- US 20060291113 A1